# EUROPÄISCHE PATENTSCHRIFT

(11) **EP 2 586 279 B1**
(45) Veröffentlichungstag und Bekanntmachung des Hinweises auf die Patenterteilung: **02.04.2014**
(21) Anmeldenummer: 11727140.3
(22) Anmeldetag: 01.06.2011
(51) Int. Cl.: H05K 5/00, H05K 7/20

(54) **ELEKTRONISCHES GERÄT MIT GEHÄUSE AUS PROFILMATERIAL**
ELECTRONIC DEVICE HAVING A HOUSING MADE OF PROFILE MATERIAL
APPAREIL ÉLECTRONIQUE COMPRENANT UN BOÎTIER EN MATÉRIAU PROFILÉ

(30) Priorität: 24.06.2010 DE 102010030460
(43) Veröffentlichungstag der Anmeldung: 01.05.2013
(73) Patentinhaber: Robert Bosch GmbH, 70442 Stuttgart (DE)
(72) Erfinder: LIPPOK, Ralf, 71522 Backnang (DE)
(86) Internationale Anmeldenummer: PCT/EP2011/059043
(87) Internationale Veröffentlichungsnummer: WO 2011/160929

(56) Entgegenhaltungen:
- EP-A1- 2 175 708
- WO-A1-2004/036972
- DE-B3- 10 334 060
- VILLEVIEILLE J M ET AL: "OPTIMIZED ANGLED HOUSING DESIGN", MOTOROLA TECHNICAL DEVELOPMENTS, MOTOROLA INC. SCHAUMBURG, ILLINOIS, US, Bd. 16, 1. August 1992 (1992-08-01), Seiten 83-84, XP000310367, ISSN: 0887-5286

## Beschreibung

### Stand der Technik

Die vorliegende Erfindung betrifft ein elektronisches Gerät mit einem geschlossenen Gehäuse aus einem Profilmaterial, z.B. aus einem Strangpressprofil, von dem das Gehäuse abgetrennt wird.

Ein solches Gerät gemäß dem Oberbegriff des Anspruches 1 ist aus der DE 103 34 060 B3 bekannt.

Ebenso ist aus der WO 2004/036972 A1 ein Gehäuse aus einem geschlossenen Profilmaterial bekannt, das zur allgemeinen Kühlung ein Kühlelement aufweist, das großflächig auf der Rückseite einer in das Gehäuse eingesetzten Platine aufliegt.

Elektronische Geräte werden in einer Vielzahl von Anwendungsfällen verwendet. Bei Fahrzeugen werden z.B. Motorsteuergeräte oder andere Steuergeräte eingesetzt, welche üblicherweise eine Schalenkonstruktion verwenden. Bei dieser Schalenkonstruktion wird ein Schaltungsträger, z.B. eine Leiterplatte, mit elektronischen/elektrischen Bauteilen in einer ersten Gehäusehalbschale angeordnet und mit einer zweiten Gehäusehalbschale verschlossen. Vor dem Schritt des Verschließens können dabei gegebenenfalls noch Bestückungsaufgaben oder andere Arbeiten an der Leiterplatte vorgenommen werden, da die Leiterplatte freiliegt und diese problemlos von oben bearbeitet werden kann. Da bei den bekannten elektronischen Geräten im Betrieb Wärme anfällt, werden üblicherweise Lösungen zur Kühlung der elektrischen Geräte mit eingebaut. Neben einer Kühlung mittels Belüftung ist es auch möglich, dass die elektronischen Bauteile über ein Wärmeleitelement direkt mit einer der Gehäusehalbschalen verbunden werden. Da bei dem schalenartigen Gehäuse der Schaltungsträger leicht zugänglich ist, kann eine besonders kostengünstige direkte Kontaktierung der elektronischen Bauteile ausgeführt werden. Hinsichtlich weiterer Kosteneinsparungen wäre es jedoch wünschenswert, die relativ aufwendig herzustellenden beiden Halbschalen des Gehäuses durch ein Gehäuse aus einem Profilelement mit geschlossenem Querschnitt zu ersetzen. Hierbei ergibt sich jedoch dann das Problem, dass eine in das Profilelement eingeführte Leiterplatte nicht mehr von oben bearbeitbar ist, wenn sie in das Gehäuse eingeschoben ist.

### Offenbarung der Erfindung

Das erfindungsgemäße elektronische/elektrische Gerät mit den Merkmalen des Anspruchs 1 weist demgegenüber den Vorteil auf, dass es ein Gehäuse aus einem Profilelement mit geschlossenem Querschnitt aufweist und trotzdem sehr kostengünstige Verfahren zur Kontaktierung von elektronischen/elektrischen Bauteilen möglich sind. Hierdurch können die Kosten für das Gehäuse durch Verwendung von Profilelementen, z.B. Strangpressprofilen, signifikant reduziert werden. Dies wird erfindungsgemäß dadurch erreicht, dass bei dem Einschubgehäuse, welches in einer Einschubrichtung für ein Trägerbauteil, wie z.B. eine Leiterplatte, eine erste und eine zweite Öffnung aufweist, wenigstens eine der beiden Öffnungen derart vorgesehen ist, dass die Öffnung in einer Ebene liegt, welche in einem Winkel kleiner 90° zur Einschubrichtung des Trägerbauteils liegt. Mit anderen Worten ist wenigstens eine der beiden Öffnungen des geschlossenen Profilgehäuses schräg zur Einschubrichtung angeordnet. Hierdurch ist es möglich, dass die Leiterplatte in das Gehäuse eingeschoben wird und zumindest an einem Endbereich, welcher an der schräg vorgesehenen Öffnung liegt, senkrecht von oben bearbeitet werden kann.

Ferner weist das elektronische Gerät erfindungsgemäß ein Abschlusselement mit einem integrierten Kühlelement auf, welches dann an die schräge Öffnung aufgesetzt wird und die schräge Öffnung verschließt. Das Kühlelement ist dann mit einem Bauteil auf dem Schaltungsträger in wärmeleitender Weise verbunden. Wärme kann somit von dem Bauelement über die wärmeleitende Verbindung an das Kühlelement im Abschlusselement abgegeben werden und von dort weiter an die Umgebung abgegeben werden.

Außerdem ist zwischen dem Kühlelement im Abschlusselement und dem elektrischen Bauteil ein wärmeleitendes Zwischenelement vorgesehen. Hierdurch kann eine direkte wärmeleitende Verbindung zwischen dem elektrischen Bauteil und dem Kühlelement erreicht werden. Weiterhin weist das wärmeleitende Zwischenelement eine elektrisch leitende Platte und ein Verbindungselement mit elastischen Eigenschaften auf. Hierdurch kann ein Toleranzausgleich zwischen dem elektronischen Bauteil und dem Kühlelement ermöglicht werden.

Die Unteransprüche zeigen bevorzugte Weiterbildungen der Erfindung.

Vorzugsweise beträgt ein Winkel zwischen der Einschubrichtung in das geschlossene Profilgehäuse und einer Ebene, in welcher die erste Öffnung liegt, zwischen 30° und 60° und beträgt besonders bevorzugt 45°. Dies gewährleistet eine ausreichende Stabilität des geschlossenen Profilelements und trotzdem eine ausreichend große, von dem Trägerbauteil senkrecht nach oben freiliegende Fläche im Bereich der Öffnung.

Gemäß einer weiteren bevorzugten Ausgestaltung der Erfindung ist das gesamte Abschlusselement als Kühlelement ausgebildet. Beispielsweise kann das Abschlusselement vollständig aus einem wärmeleitenden Material, insbesondere einem Metallmaterial, hergestellt sein. Weiter bevorzugt ist das Abschlusselement direkt mit dem Gehäuse verbunden, so dass auch zusätzlich noch eine Wärmeleitung in den Gehäusebereich ermöglicht wird.

Für eine besonders gute Wärmeableitung umfasst das Kühlelement vorzugsweise eine oder eine Vielzahl von Kühlrippen.

Bevorzugt ist das elastische Verbindungselement eine wärmeleitende Paste oder eine flexible, wärmeleitende Folie. Hierdurch ist eine wärmeleitende Verbindung durch die Slug-up-Technik möglich.

Für eine besonders schnelle und kostengünstige Montage ist vorzugsweise ein Trägerbauteil mit einem zweiten Abschlusselement direkt verbunden, wobei das zweite Abschlusselement die zweite Öffnung des Gehäuseprofils verschließt. Besonders bevorzugt ist hierbei im zweiten Abschlusselement eine Steckverbindung vorgesehen, so dass eine einfache, steckbare Verbindung zu dem elektronischen Gerät möglich ist.

Gemäß einer weiteren bevorzugten Ausgestaltung der vorliegenden Erfindung ist die zweite Öffnung des Profilgehäuses ebenfalls schräg abgeschnitten, so dass die Öffnung in einer Ebene liegt, die in einem Winkel zur Einschubrichtung ausgerichtet ist. Hierdurch können an beiden Enden des Trägerbauteils elektronische Bauteile vorgesehen werden, welche dann mit Kühlelementen verbunden werden können, die in den beiden Abschlusselementen integriert sind. Diese Varianten mit zwei schrägen Öffnungen am Profilgehäuse eignen sich besonders für elektronische Geräte, die eine Vielzahl von Wärme abgebenden, elektronischen Bauteilen aufweisen. Die elektronischen Bauteile können dann an einem Anfang oder einem Ende des Trägerbauteils angeordnet werden.

Gemäß einer weiteren bevorzugten Ausgestaltung der Erfindung sind am Schaltungsträger eine Vielzahl von elektronischen Bauteilen angeordnet, welche mit einem gemeinsamen Kühlelement im Abschlusselement verbunden sind. Hiermit kann insbesondere ein sehr einfacher Aufbau erreicht werden.

### Zeichnung

Nachfolgend wird ein bevorzugtes Ausführungsbeispiel der Erfindung unter Bezugnahme auf die begleitende Zeichnung im Detail beschrieben. In der Zeichnung ist:
- Figur 1: eine schematische Längsschnittansicht eines elektronischen Geräts gemäß einem bevorzugten Ausführungsbeispiel der Erfindung, und
- Figur 2: eine schematische Querschnittsansicht des in Figur 1 gezeigten Geräts.

### Bevorzugte Ausführungsform der Erfindung

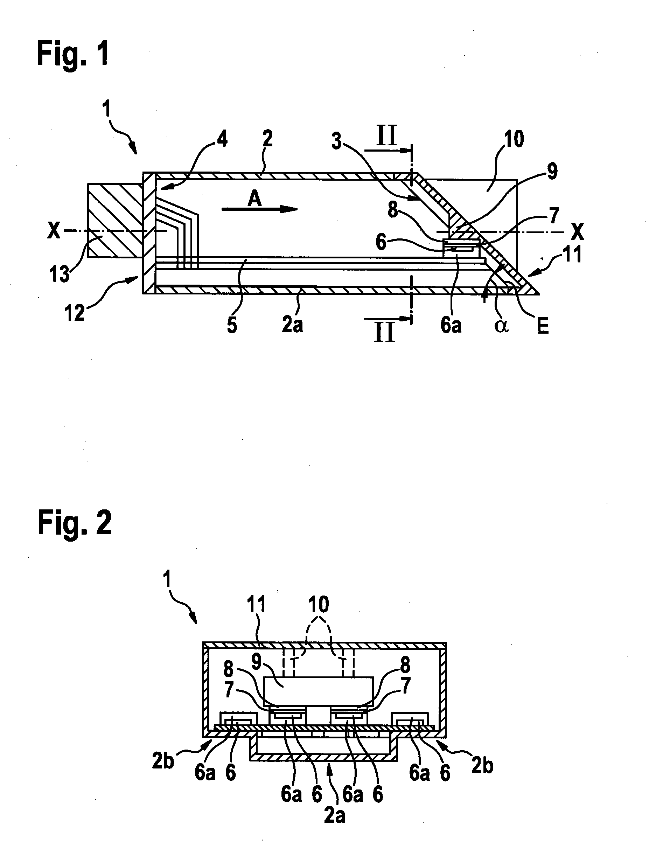

Nachfolgend wird unter Bezugnahme auf die Figuren 1 und 2 ein bevorzugtes Ausführungsbeispiel der Erfindung im Detail beschrieben.

Wie aus Figur 1 ersichtlich ist, umfasst das erfindungsgemäße elektronische/elektrische Gerät 1 ein geschlossenes Einschubgehäuse 2, welches aus einem Profilmaterial hergestellt ist. In Figur 2 ist der Querschnitt des Profilmaterials ersichtlich, welches im Wesentlichen rechteckig ist, wobei an der Unterseite des im Wesentlichen rechteckigen Profilmaterials noch ein zusätzlicher mittiger rechteckiger Bereich 2a ausgebildet ist. In Figur 1 ist eine Einschubrichtung, in welcher eine Leiterplatte 5 in das Einschubgehäuse 2 eingeschoben wird, mit dem Pfeil A angedeutet.

Das Einschubgehäuse 2 umfasst eine erste Öffnung 3 sowie eine zweite Öffnung 4, welche jeweils an den Enden des Einschubgehäuses 2 angeordnet ist. Die zweite Öffnung 4 ist dabei mittels eines zweiten Abschlusselements 12 verschlossen, wobei am zweiten Abschlusselement 12 ein Steckeranschluss 13 angeordnet ist. Die zweite Öffnung 4 ist dabei derart ausgebildet, dass eine Öffnungsfläche senkrecht zu einer Längsachse X-X des Einschubgehäuses ist. Die erste Öffnung 3 ist dagegen durch ein schräg abgeschnittenes Ende des Einschubgehäuses 2 gebildet, so dass eine Ebene E, in der die erste Öffnung 3 liegt, in einem Winkel α zur Längsachse X-X des Einschubgehäuses 2 angeordnet ist. Der Winkel α beträgt in diesem Ausführungsbeispiel 45°, kann jedoch beliebig gewählt werden. Besonders bevorzugt wird hierbei ein Bereich zwischen 30 und 60° als Winkel α ausgewählt.

An der Leiterplatte 5 sind ferner elektronische und/oder elektrische Bauteile 6 in verschiedenen Arten angeordnet. Die in Figur 2 gezeigten beiden mittleren elektronischen Bauteile 6 sind dabei in einem Pad 6a, welches auf der Leiterplatte 5 befestigt ist, angeordnet. Die beiden äußeren elektronischen Bauteile 6 sind direkt auf der Leiterplatte 5 angeordnet und werden von jeweils einem Pad 6a abgedeckt.

Wie aus Figur 2 ersichtlich ist, ist bei den beiden mittleren elektronischen Bauteilen 6 an der nach oben freiliegenden Seite eine elektrisch leitende Platte 7 (heat slug) fixiert. Auf der elektrisch leitenden Platte 7 ist dann zusätzlich ein Verbindungselement 8 mit elastischen Eigenschaften fixiert, welches eine Verbindung mit einem Kühlelement 9 herstellt. Das Verbindungselement 8 ist dabei eine elektrisch leitfähige Paste oder eine elektrisch leitfähige Folie. Da die Paste bzw. Folie elastische Eigenschaften aufweisen, können hierdurch Toleranzen ausgeglichen werden. Das Kühlelement 9 ist in Form einer Kühlbank vorgesehen, welche an einem ersten Abschlusselement 11 angeordnet ist. Das erste Abschlusselement 11 verschließt dabei die schräge erste Öffnung 3. An einer Außenseite des ersten Abschlusselements 11 sind ferner zwei Kühlrippen 10 angeordnet. Diese Kühlrippen verbessern die Kühlung über das Kühlelement 9. Wie weiter aus Figur 2 ersichtlich ist, werden die beiden äußersten elektronischen Bauteile 6 über in der Leiterplatte 5 vorgesehene thermische Durchgangsbohrungen, in welchen Kupferleitungen angeordnet sind, zur Unterseite der Leiterplatte 5 gekühlt, wobei die Unterseite der Leiterplatte 5 dabei auf Kühlbereichen 2b des Einschubgehäuses 2 aufliegt. Hierdurch kann eine ausreichende Kühlung dieser elektronischen Bauteile 6 erfolgen.

Durch die erfindungsgemäße Idee des schrägen Abschneidens eines geschlossen Profilelements zur Herstellung des Einschubgehäuses wird es ermöglicht, dass elektronische Bauteile 6, welche an einem Endbereich der Leiterplatte 5 angeordnet sind, die zur ersten Öffnung 3 gerichtet sind, senkrecht von oben bearbeitet werden können. Hierdurch kann die sogenannte Slug-up-Technik verwendet werden, bei der das elektronische Bauteil 6 von der Oberseite mit einer elektrisch leitenden Platte 7 verbunden wird, auf welche dann das Verbindungselement 8 mit elastischen Eigenschaften aufgebracht wird. Diese Technik ist sehr kostengünstig, kann bisher im Stand der Technik jedoch nicht bei Einschubgehäusen eingesetzt werden, da die Einschubgehäuse rundum geschlossen sind und die gesamte Leiterplatte überdecken, so dass eine Bearbeitung der elektronischen Bauteile 6 von oben in einer senkrechten Richtung zur Leiterplatte 5 bisher nicht möglich ist. Somit kann durch die vorliegende Erfindung einerseits die Slug-up-Technik eingesetzt werden und andererseits können geschlossene Profilgehäuse verwendet werden, wodurch die Herstellungskosten derartiger elektronischer Geräte signifikant sinken. Ein Einsatzgebiet dieser elektronischen Geräte sind beispielsweise Steuergeräte in Fahrzeugen für verschiedene Anwendungen.

Die schräge erste Öffnung 3 wird dabei vollständig durch das erste Abschlusselement 11 verschlossen, wobei zwischen dem Einschubgehäuse 2 und dem ersten Abschlusselement 11 eine formschlüssige und/oder kraftschlüssige Verbindung möglich ist. Auch können andere Verbindungstechniken, wie z.B. Schweißen oder Kleben, eingesetzt werden. Als Profilelement für die Einschubgehäuse werden bevorzugt Strangpressprofile verwendet. Wenn das Strangpressprofil symmetrisch zu einer Mittelebene in Einschubrichtung ist, z.B. wenn das Strangpressprofil rechteckig ist, und der Winkel α, in welcher die Öffnungsfläche an der ersten Öffnung 3 angeordnet ist, 45° beträgt, ist es auch möglich, dass von dem Strangpressprofil jeweils gleichartige Einschubgehäuse 2 abgeschnitten werden, da jedes zweite abgeschnittene Einschubgehäuse lediglich um 180° gedreht werden muss und dann in gleicher Weise verwendet werden kann.

Ferner ist es erfindungsgemäß möglich, dass von einem Strangpressprofil auch Einschubgehäuse mit unterschiedlichen Längen in axialer Richtung abgeschnitten werden, so dass eine hohe Flexibilität der Produktion hinsichtlich der Länge der Einschubgehäuse besteht.

Es sei ferner angemerkt, dass selbstverständlich auch die beiden Öffnungen 3, 4 schräg vom Profilelement abgesägt werden können, so dass elektronische Bauteil 6 an beiden Enden der Leiterplatte 5 senkrecht von oben bearbeitet werden können.

Ferner wird durch die vorliegende Erfindung eine direkte Kontaktierung der elektronischen Bauteile 6 von oben mittels eines Abschlusselements ermöglicht. Hierdurch können Einschubgehäuse 2 aus Profilelementen verwendet werden und die an einem Ende der Leiterplatte 5 liegenden elektronischen Bauteile können direkt von einem in das Abschlusselement 11 integrierten Kühlelement 9 kontaktiert werden. Dies ermöglicht eine besonders gute Wärmeabfuhr. Somit eignet sich die vorliegende Erfindung insbesondere bei Anwendungsfällen, in denen die elektronischen Bauteile relativ viel Wärme abgeben.

Die beiden Abschlusselemente 11, 12 sind dabei vorzugsweise auf das Einschubgehäuse 2 aufsteckbar ausgebildet.

## Patentansprüche

1. Elektronisches Gerät, umfassend
- ein Einschubgehäuse (2), welches aus einem Profilelement mit geschlossenem Querschnitt hergestellt ist und welches eine erste Öffnung (3) und eine zweite Öffnung (4) aufweist,
- eine Leiterplatte (5) mit wenigstens einem elektronischen Bauteil (6), und
- ein erstes Abschlusselement (11), wobei das erste Abschlusselement (11) an der ersten Öffnung (3) angeordnet ist und wobei die erste Öffnung (3) in einer Ebene (E) liegt, welche in einem Winkel (□) kleiner 90° zu einer Einschubrichtung (A) der Leiterplatte (5) angeordnet ist,
**dadurch gekennzeichnet,**
- **dass** das erste Abschlusselement (11) ein Kühlelement (9) umfasst, welches mit dem elektronischen Bauteil (6) in wärmeleitender Weise verbunden ist,
- **dass** zwischen dem elektronischen Bauteil (6) und dem Kühlelement (9) wenigstens ein wärmeleitendes Zwischenelement angeordnet ist, und
- das wärmeleitende Zwischenelement eine elektrisch leitende Platte (7) umfasst, welche direkt auf dem elektronischen Bauteil (6) angeordnet ist, und ein Verbindungselement (8) mit elastischen Eigenschaften umfasst.

2. Elektronisches Gerät nach einem der vorhergehenden Ansprüche, **dadurch gekennzeichnet, dass** der Winkel (α) vorzugsweise zwischen 30° und 60° liegt und besonders bevorzugt 45° ist.

3. Elektronisches Gerät nach einem der vorhergehenden Ansprüche, **dadurch gekennzeichnet, dass** das gesamte Abschlusselement (12) als Kühlelement ausgebildet ist.

4. Elektronisches Gerät nach einem der vorhergehenden Ansprüche, **dadurch gekennzeichnet, dass** das Kühlelement (9) des Abschlusselements direkt mit dem Einschubgehäuse (2) verbunden ist.

5. Elektronisches Gerät nach einem der vorhergehenden Ansprüche, **dadurch gekennzeichnet, dass** am Abschlusselement (11) Kühlrippen (10) vorgesehen sind.

6. Elektronisches Gerät nacheinem der vorhergehenden Ansprüche, **dadurch gekennzeichnet, dass** das Verbindungselement (8) mit elastischen Eigenschaften eine Paste und/oder eine Folie ist.

7. Elektronisches Gerät nach einem der vorhergehenden Ansprüche, **dadurch gekennzeichnet, dass** die zweite Öffnung (4) des Einschubgehäuses mit einem zweiten Abschlusselement (12) verschlossen ist, wobei am zweiten Abschlusselement (12) eine Steckverbindung (13) angeordnet ist und durch das zweite Abschlusselement (12) hierdurch eine elektrische Verbindung zwischen der Steckverbindung und der Leiterplatte (5) vorgesehen ist.

## Claims

1. Electronic device comprising
- an insertion housing (2) that is produced from a profile element having a closed cross-section and that comprises a first opening (3) and a second opening (4),
- a circuit board (5) having at least one electronic component (6), and
- a first end piece (11), wherein the first end piece (11) is arranged on the first opening (3) and wherein the first opening (3) lies in a plane (E) which is arranged at an angle (α) that is smaller than 90° with respect to a direction (A) in which the circuit board (5) is inserted, **characterized**
- **in that** the first end piece (11) comprises a cooling element (9) that is connected in a heat-conducting manner to the electronic component (6),
- **in that** at least one heat-conducting intermediate element is arranged between the electronic component (6) and the cooling element (9), and
- the heat-conducting intermediate element comprises an electrically conductive plate (7) that is arranged directly on the electronic component (6) and comprises a connecting element (8) that has elastic properties.

2. Electronic device according to Claim 1, **characterized in that** the angle (α) preferably lies between 30° and 60° and particularly preferred is 45°.

3. Electronic device according to any one of the preceding claims, **characterized in that** the entire end piece (12) is embodied as a cooling element.

4. Electronic device according to any one of the preceding claims, **characterized in that** the cooling element (9) of the end piece is connected directly to the insertion housing (2).

5. Electronic device according to any one of the preceding claims, **characterized in that** cooling ribs (10) are provided on the end piece (11).

6. Electronic device according to one of the preceding claims, **characterized in that** the connecting element (8) that has elastic properties is a paste and/or a film.

7. Electronic device according to any one of the preceding claims, **characterized in that** the second opening (4) of the insertion housing is closed by a second end piece (12), wherein a plug-in connector (13) is arranged at the second end piece (12) and consequently an electrical connection is provided between the plug-in connector and the circuit board (5) by virtue of the second end piece (12).

## Revendications

1. Appareil électronique comprenant :
- un boîtier d'insertion (2) fabriqué en un élément profilé de section transversale fermée, qui présente une première ouverture (3) et une deuxième ouverture (4),
- une carte à circuits imprimés (5) comprenant au moins un composant électronique (6), et
- un premier élément de terminaison (11), le premier élément de terminaison (11) étant disposé au niveau de la première ouverture (3) et la première ouverture (3) étant située dans un plan (E) qui est disposé suivant un angle (α) < 90° par rapport à une direction d'insertion (A) de la carte à circuits imprimés (5),
**caractérisé en ce que**
- le premier élément de terminaison (11) comprend un élément de refroidissement (9) qui est connecté au composant électronique (6) de manière thermoconductrice,
- entre le composant électronique (6) et l'élément de refroidissement (9) est disposé au moins un élément intermédiaire thermoconducteur, et
- l'élément intermédiaire thermoconducteur comprend une plaque électriquement conductrice (7) qui est disposée directement sur le composant électronique (6), et qui comprend un élément de connexion (8) ayant des propriétés élastiques.

2. Appareil électronique selon la revendication 1, **caractérisé en ce que** l'angle (α) est de préférence compris entre 30° et 60°, et vaut particulièrement préférablement 45°.

3. Appareil électronique selon l'une quelconque des revendications précédentes, **caractérisé en ce que** tout l'élément de terminaison (12) est réalisé sous forme d'élément de refroidissement.

4. Appareil électronique selon l'une quelconque des revendications précédentes, **caractérisé en ce que** l'élément de refroidissement (9) de l'élément de terminaison est connecté directement au boîtier d'insertion (2).

5. Appareil électronique selon l'une quelconque des revendications précédentes, **caractérisé en ce que** l'élément de terminaison (11) présente des ailettes de refroidissement (10).

6. Appareil électronique selon l'une quelconque des revendications précédentes, **caractérisé en ce que** l'élément de connexion (8) ayant des propriétés élastiques est une pâte et/ou un film.

7. Appareil électronique selon l'une quelconque des revendications précédentes, **caractérisé en ce que** la deuxième ouverture (4) du boîtier d'insertion est fermée avec un deuxième élément de terminaison (12), une connexion enfichable (13) étant disposée sur le deuxième élément de terminaison (12) et une connexion électrique étant ainsi prévue entre la connexion enfichable et la carte à circuits imprimés (5) par le biais du deuxième élément de terminaison (12).
